(19) Europäisches Patentamt / European Patent Office / Office européen des brevets

(11) **EP 3 502 753 B1**

(12) **FASCICULE DE BREVET EUROPEEN**

(45) Date de publication et mention
de la délivrance du brevet:
**25.05.2022 Bulletin 2022/21**

(21) Numéro de dépôt: **18206429.5**

(22) Date de dépôt: **15.11.2018**

(51) Classification Internationale des Brevets (IPC):
**G01V 99/00** *(2009.01)*     *G06F 30/23 (2020.01)*
*E21B 43/00 (2006.01)*

(52) Classification Coopérative des Brevets (CPC):
**G01V 99/005;** E21B 43/00; G01V 2210/661;
G06F 30/23

(54) **PROCEDE DE MODELISATION D'UN BASSIN SEDIMENTAIRE**

MODELLIERUNGSVERFAHREN EINES SEDIMENTBECKENS

METHOD FOR MODELLING A SEDIMENTARY BASIN

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **22.12.2017 FR 1762937**

(43) Date de publication de la demande:
**26.06.2019 Bulletin 2019/26**

(73) Titulaire: **IFP Energies nouvelles
92852 Rueil-Malmaison Cedex (FR)**

(72) Inventeurs:
- **DUCROS, Mathieu
92500 RUEIL-MALMAISON (FR)**
- **FAILLE, Isabelle
78420 CARRIERES SUR SEINE (FR)**
- **PEGAZ-FIORNET, Sylvie
78160 MARLY-LE-ROI (FR)**
- **TRABY, Renaud
78620 L'ETANG LA VILLE (FR)**
- **WILLIEN, Françoise
92500 RUEIL MALMAISON (FR)**
- **WOLF, Sylvie
92500 Rueil-Malmaison (FR)**

(74) Mandataire: **IFP Energies nouvelles
Département Propriété Industrielle
Rond Point de l'échangeur de Solaize
BP3
69360 Solaize (FR)**

(56) Documents cités:
**EP-A1- 2 110 686**     **EP-A1- 3 182 176**
**US-A1- 2010 223 039**

- **I FAILLE ET AL: "Modeling Fluid Flow in Faulted
Basins", OIL & GAS SCIENCE & TECHNOLOGY:
REVUE DE L'INSTITUT FRANCAIS DU PETROLE,
vol. 69, no. 4, 18 avril 2014 (2014-04-18) , pages
529-553, XP055503042, FR ISSN: 1294-4475, DOI:
10.2516/ogst/2013204**

**Description**

DOMAINE TECHNIQUE GENERAL

La présente invention concerne un procédé de modélisation d'un bassin sédimentaire.

ETAT DE L'ART

On connait des outils de « modélisation de bassin » qui permettent de simuler numériquement la formation d'un bassin sédimentaire. On citera par exemple l'outil décrit dans le brevet EP2110686 (US8150669) ou les demandes de brevet EP2816377 (US2014/0377872), EP3075947 (US2016/0290107), EP3182176 (US2017/0177764).
Ces outils informatiques permettent de simuler en une, deux ou trois dimensions l'ensemble des processus sédimentaires, tectoniques, thermiques, hydrodynamiques et de chimie organique et inorganique qui interviennent lors de la formation d'un bassin sédimentaire.
La modélisation numérique des bassins sédimentaires est un outil important pour l'exploration du sous-sol et en particulier l'exploration pétrolière. Un de ses objectifs consiste à prédire le champ de pression à l'échelle du bassin sédimentaire sur la base notamment d'informations géologiques, géophysiques et de données de forage. Dans le cadre de l'exploration pétrolière, les données qui permettent de construire de tels modèles proviennent généralement :

- des expertises et des études géologiques d'évaluation du potentiel pétrolier du bassin sédimentaire, réalisées à partir des données disponibles (affleurements, campagnes sismiques, forages). Cette expertise vise à :

  ▪ mieux comprendre l'architecture et l'histoire géologique du sous-sol, notamment à étudier si des processus de maturation et de migration d'hydrocarbures ont pu se mettre en place ;
  ▪ identifier les zones du sous-sol dans lesquelles ces hydrocarbures ont pu s'accumuler ;
  ▪ établir quelles zones présentent le meilleur potentiel économique, évalué à partir du volume et de la nature des hydrocarbures probablement piégés (viscosité, taux de mélange avec de l'eau, composition chimique ...), ainsi que de leur coût d'exploitation (contrôlé par exemple par la profondeur et la pression de fluide).

- des forages d'exploration dans les différentes zones présentant le meilleur potentiel, afin de confirmer ou infirmer le potentiel estimé préalablement, et d'acquérir de nouvelles données pour alimenter de nouvelles études plus précises.

De façon classique, les algorithmes de modélisation de bassin comportent trois étapes principales :

1. une phase de construction d'un maillage du sous-sol suivant une hypothèse sur son architecture interne et sur les propriétés qui caractérisent chaque maille : par exemple leur porosité, leur nature sédimentaire (argile, sable, etc.) ou encore leur teneur en matière organique au moment de leur sédimentation. La construction de ce modèle se base sur des données acquises par campagnes sismiques ou mesures en forages par exemple. Ce maillage est structuré en couches : un groupe de mailles est affecté à chaque couche géologique du bassin modélisé.
2. une phase de reconstruction du maillage représentant des états antérieurs de l'architecture du bassin. Cette étape est réalisée à l'aide, par exemple, d'une méthode de "backstripping" (Steckler, M.S., and A.B. Watts, Subsidence of the Atlantic-type continental margin off New York, Earth Planet. Sci. Lett., 41, 1-13, 1978.) ou une méthode de restauration structurale (voir la demande de brevet EP2110686 (US8150669) susmentionnée).
3. une étape de simulation numérique d'une sélection de phénomènes physiques se déroulant au cours de l'évolution du bassin et contribuant à la formation des pièges pétroliers. Cette étape s'appuie sur une représentation discrétisée du temps en « événements », chaque événement étant simulé par une succession de pas de temps. Le début et la fin d'un événement correspondent à deux états successifs de l'évolution de l'architecture du bassin fournis à l'étape 2 précédente. Le nombre de pas de temps, généralement compris entre quelques-uns et plusieurs centaines, peut être fixe ou évolutif pour s'adapter à la complexité des mécanismes physiques et géologiques.

Il est souhaitable d'utiliser un pas de temps le plus bref possible pour améliorer d'autant la qualité du modèle et sa représentativité de la réalité (c'est un enjeu majeur pour pouvoir procéder à des forages pétroliers ensuite notamment), mais une telle démarche est rapidement limitée par la capacité et les ressources des processeurs actuels.
Même en utilisant des supercalculateurs onéreux, le temps nécessaire à la modélisation d'un bassin est conséquent.
Il serait souhaitable d'améliorer l'efficacité informatique des procédés actuels de sorte à pouvoir les mettre en œuvre sans perte de qualité sur du matériel courant en un temps raisonnable.

L'invention vient améliorer la situation.

PRESENTATION DE L'INVENTION

L'invention propose selon un premier aspect un procédé de modélisation d'un bassin sédimentaire, ledit bassin sédimentaire ayant subi une pluralité d'événements géologiques définissant une séquence d'états {$A_i$} du bassin, chacun desdits états s'étendant entre deux événements géologiques successifs, le procédé comprenant la mise en œuvre par des moyens de traitement de données d'étapes de :

(a) Obtention de mesures de grandeurs physiques dudit bassin acquises depuis des capteurs ;
(b) Pour chacun desdits états $A_i$, construction d'une représentation maillée dudit bassin en fonction desdites mesures de grandeurs physiques ;
(c) Pour chacun desdits états $A_i$, et pour chaque maille de ladite représentation maillée,

1. calcul d'une contrainte effective appliquée sur la maille à la fin de l'état $A_i$ , ladite contrainte effective à la fin dudit état $A_i$ étant calculée en fonction de ladite contrainte effective à la fin de l'état précédent $A_{i-1}$ et d'une contrainte effective additionnelle sur ledit état $A_i$ fonction d'une variation d'épaisseur de sédiment pendant ledit état $A_i$;
2. calcul d'une surpression dans la maille à la fin de l'état $A_i$ en fonction de ladite contrainte effective calculée à la fin de l'état $A_i$.

Le procédé selon l'invention est avantageusement complété par les caractéristiques suivantes, prises seules ou en une quelconque de leur combinaison techniquement possible :

- le procédé comprend une étape (d) de sélection des zones dudit bassin correspondant à des mailles de ladite représentation maillée dudit bassin au temps actuel comportant des hydrocarbures ;
- l'étape (d) comprend l'exploitation dudit bassin en fonction desdites zones sélectionnées ;
- l'étape (b) est mise en œuvre par backstripping ou reconstruction structurale ;
- l'étape (b) comprend pour chaque maille et chaque état $A_i$ la détermination d'une contrainte verticale totale sur la maille, ladite contrainte effective additionnelle étant calculée à l'étape (c) comme la contrainte verticale totale additionnelle $A_i$ par rapport à l'état précédent $A_{i-1}$, moins la pression hydrostatique équivalente à la variation d'épaisseur de sédiment ;
- l'étape (c).2 comprend le calcul d'un taux de variation de la contrainte effective pendant l'état $A_i$ en fonction de la contrainte effective à la fin de l'état $A_i$ et de la contrainte effective à la fin de l'état précédent $A_{i-1}$ ;
- l'étape (c).2 comprend le calcul d'un taux de variation d'un volume poreux de la maille pendant l'état $A_i$ en supposant constant le taux de variation de la contrainte effective pendant l'état $A_i$, de sorte à obtenir la surpression à la fin de l'état $A_i$ par résolution d'une équation de Darcy simplifiée ;
- l'étape (c) comprend une étape préalable (c).0 de vérification que pour au moins une desdites mailles la surpression a varié pendant l'état $A_i$ de plus qu'au moins un seuil prédéterminé, et de mise en œuvre de la suite de l'étape (c) seulement si cela est vérifié ;
- l'étape (c).0 comprend le calcul d'une valeur de surpression théorique qui se développerait dans la maille sous l'hypothèse d'une pression hydrostatique ;
- l'étape (c).0 comprend en outre la vérification que pour au moins une desdites mailles la surpression a varié depuis le dernier état $A_{j,j<i}$ lors duquel la suite de l'étape (c) a été mise en œuvre, de plus qu'un deuxième seuil prédéterminé ;
- l'étape (c).0 comprend le calcul pour chaque maille d'un indicateur :

  - Si pour chaque maille la valeur calculée de surpression théorique qui se développerait dans la maille sous l'hypothèse d'une pression hydrostatique est inférieure audit premier seuil, chaque indicateur est incrémenté de la valeur calculée de surpression théorique qui se développerait dans la maille sous l'hypothèse d'une pression hydrostatique ;
  - Si pour au moins une maille la valeur calculée de surpression théorique qui se développerait dans la maille sous l'hypothèse d'une pression hydrostatique est supérieure audit premier seuil ou la valeur de l'indicateur est supérieure audit deuxième seuil, chaque indicateur est remis à zéro.

Selon un autre aspect, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé selon le premier aspect de l'invention, lorsque ledit programme est exécuté sur un ordinateur.

PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :

-    la figure 1 est un diagramme représentant la pression en fonction de la profondeur dans un exemple de milieu sédimentaire ;
-    La figure 2a représente schématiquement un procédé connu de modélisation d'un bassin sédimentaire ;
-    La figure 2b représente schématiquement le procédé de modélisation d'un bassin sédimentaire selon l'invention ;
-    La figure 2c représente schématiquement le procédé de modélisation d'un bassin sédimentaire selon un mode de réalisation préféré de l'invention ;
-    La figure 3 illustre le découplage entre la détermination de la contrainte effective et de la détermination de la surpression ;

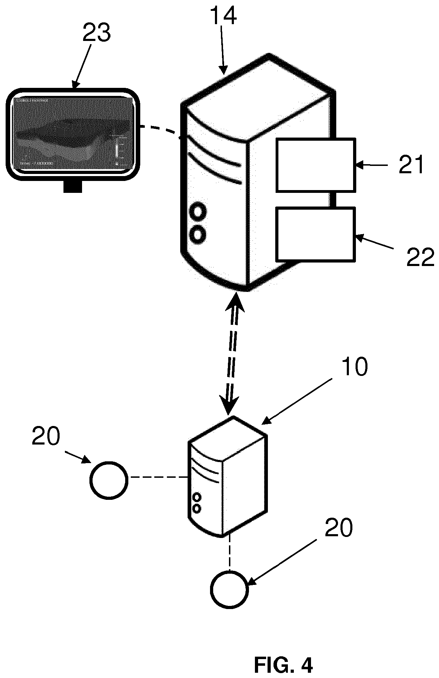

-    La figure 4 représente une architecture de système pour la mise en œuvre du procédé selon l'invention,
-    La figure 5 représente un exemple de lissage d'une courbe porosité/contrainte ;
-    Les figures 6a et 6b représentent deux exemples de modélisation d'un bassin sédimentaire sans et avec le procédé selon l'invention.

DESCRIPTION DETAILLEE

*Principe de l'invention*

Un modèle de bassin fournit une cartographie prédictive du sous-sol indiquant notamment la pression dans le bassin (champ de pression) au cours de son histoire géologique.

Pour cela, une partie conséquente du temps de calcul de la partie de simulation itérative est liée à la modélisation des phénomènes d'écoulement d'eau dans le bassin.

On appelle pression hydrostatique la pression d'équilibre qui s'établit dans les pores d'un milieu poreux s'il existe un chemin suffisamment perméable joignant le point d'étude à la surface. C'est aussi la pression qu'on obtiendrait dans une colonne d'eau à la même profondeur.

La pression lithostatique constitue une généralisation aux milieux rocheux solides du concept de pression hydrostatique s'appliquant aux milieux liquides et gazeux. C'est la pression qu'on obtiendrait dans une colonne de roche à la même profondeur.

Les gradients hydrostatique et lithostatique correspondent à la variation des pressions hydrostatique et lithostatique par unité de profondeur.

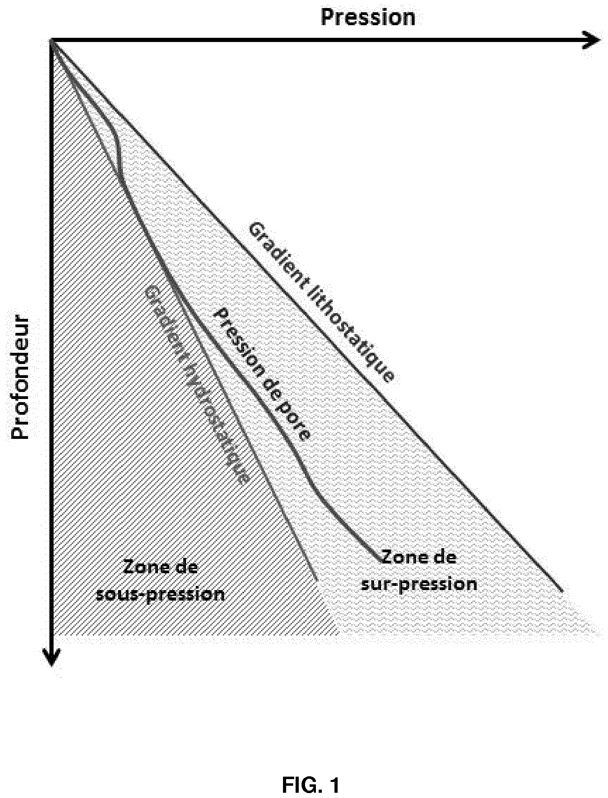

En référence à la **figure 1**, on constate que la pression du fluide constatée dans les pores de la roche (appelée pression de pore constatée) suit généralement la même évolution que la pression hydrostatique. Toutefois, dans certaines conditions géologiques la pression de pore peut s'écarter de ce comportement normal.

On appelle surpression/sous-pression l'écart entre la pression de pore et la pression hydrostatique (les zones de surpression et de surpression sont représentées sur la figure 1).

En effet, les bassins sédimentaires sont, aux exceptions notables des accumulations de gaz ou d'hydrocarbures, saturés en eau. Les processus de sédimentation et d'érosion conduisent cependant à des variations, au cours des temps géologiques, de la charge verticale dans les bassins sédimentaires. Ces variations de charge induisent la compaction ou l'expansion des roches, phénomènes responsables de la mise en mouvement des fluides qu'elles contiennent, généralement de l'eau plus ou moins saumâtre. Si la perméabilité des roches permet l'écoulement des fluides, la pression reste à l'équilibre hydrostatique, mais s'en éloigne dans le cas contraire. La pression de pore peut donc être supérieure (surpression) ou inférieure (sous-pression) à la pression hydrostatique lorsque, par exemple, la perméabilité ne permet pas à l'eau de s'écouler facilement au sein de la roche.

Différents phénomènes peuvent être à l'origine de surpressions (Grauls, D., Overpressure assessment using a minimum principal stress approach - Overpressures in petroleum exploration ; Proc Workshop, Paul, Avril 1998 - Bulletin du centre de recherche Elf Exploration et Production, Mémoire 22, 137-147, ISSN : 1279-8215, ISBN : 2-901 026-49-4). Parmi les phénomènes majeurs on trouve par exemple :

-    Le déséquilibre de compaction : pendant un épisode de sédimentation, le domaine sédimentaire est soumis à une augmentation de la contrainte lithostatique (par l'accroissement du poids des roches sus-jacentes). La porosité des roches diminue, entraînant une augmentation de la pression du fluide présent dans le milieu poreux. Toutefois, si le fluide est libre de circuler, il tendra à s'évacuer afin de retrouver la pression hydrostatique. Il y a donc compétition entre la vitesse d'expulsion du fluide et la capacité de la roche à se compacter. Or, plus la perméabilité est faible, plus le temps de diffusion du fluide est grand. Pour une vitesse de sédimentation donnée, il existe donc une perméabilité critique en dessous de laquelle les surpressions se développent.

- La dilatation des fluides : sous l'effet d'une élévation de température, le fluide tend à se dilater. A volume de pores constant, on a alors une augmentation de pression.
- Une source de fluides internes : certaines réactions minérales, comme la transformation de smectite en illite, génèrent de l'eau. Par ailleurs, la maturation de la roche mère à l'origine d'hydrocarbures transforme un solide en fluide (on parle alors de porosité organique ou porosité secondaire). Dans ces deux cas, il y a une génération de fluide en profondeur et donc le développement de surpressions.

Pour connaître les écoulements d'eau et les pressions qui en résultent au temps actuel, il est nécessaire de simuler les écoulements d'eau au cours de l'histoire sédimentaire du bassin dans l'étape itérative.

Pour cela, les écoulements fluides sont calculés en utilisant la loi classique de Darcy :

$$\mathbf{u} = -\frac{K}{\mu}(\overrightarrow{\mathbf{grad}}P - \rho\,\vec{g})$$

avec $u$ la vitesse de déplacement du fluide (de l'eau dans le cas de la modélisation des bassins sédimentaires) dans le milieu, $K$ la perméabilité du milieu pour le fluide considéré, $\mu$ est la viscosité du fluide et $\rho$ sa masse volumique, $g$ l'accélération de la pesanteur, et $P$ la pression de pore.

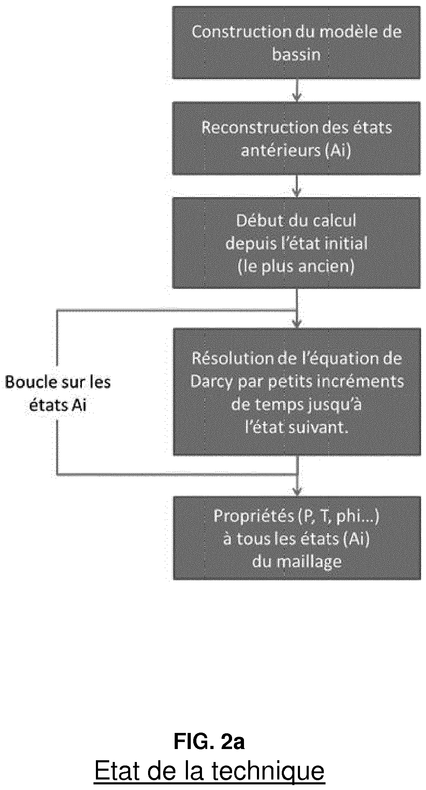

En référence à la **figure 2a,** qui représente le déroulé d'un procédé typique, le calcul du champ de pression dans un modèle numérique de bassin sédimentaire repose sur la résolution couplée, à l'échelle du bassin sédimentaire, de l'évolution de la contrainte verticale, de l'évolution de la porosité des roches, de l'évolution de leur perméabilité et de l'évolution des propriétés (densité et viscosité notamment) et des volumes de fluides.

Plus précisément, comme expliqué dans l'introduction, si on appelle $\{A_i\}_{i\in[\![0;n]\!]}$ l'ensemble des états, deux états étant séparés par un événement d'ordre géologique, alors pour chaque état $A_i$ il est nécessaire de résoudre l'équation de Darcy par petits incréments de temps (i.e. avec un petit pas de temps $dt$) jusqu'à l'état suivant $A_{i+1}$.

Et alors, que le nombre d'états $A_i$ est au final relativement limité, il est nécessaire d'avoir plusieurs centaines d'incréments par état pour avoir une bonne qualité de modélisation.

Afin de déterminer l'ensemble des propriétés susmentionnées, la résolution des équations de conservation de la masse couplée à l'équation de Darcy requiert ainsi des temps de calcul qui peuvent être très longs, de quelques minutes à plusieurs heures, selon la dimension du modèle numérique (nombre de mailles et nombre d'événements géologiques) et selon la complexité des phénomènes géologiques et physiques.

Ce problème de la complexité de la résolution de l'équation de Darcy est bien connu de l'homme du métier versé en algorithmique. Il a d'ailleurs été proposé dans le document US 2010/0223039 de simplifier les équations en faisant des hypothèses sur les phénomènes physiques impliqués. Cela est efficace mais s'avère très complexe à gérer au vu de la multiplicité des phénomènes et peut altérer la qualité.

Le présent procédé propose au contraire une astuce algorithmique permettant dans tous les cas d'augmenter sensiblement le pas de temps (et donc de diminuer le nombre d'itérations nécessaires pour chaque état). Comme l'on verra, un seul « grand » incrément peut suffire pour un état, et au pire quelques dizaines, ce qui diminue au moins d'un ordre de grandeur le nombre d'itérations nécessaire pour la mise en œuvre du procédé.

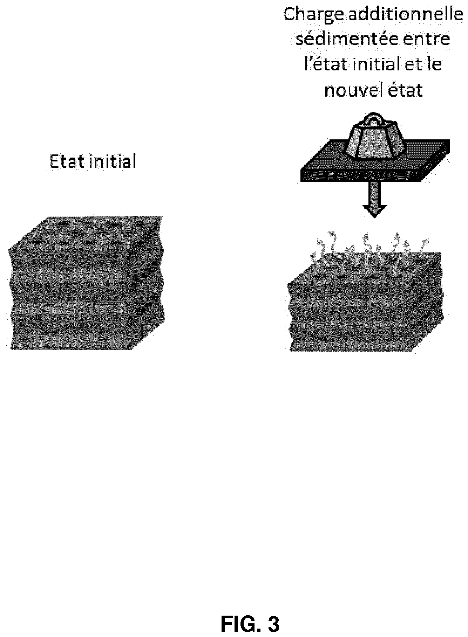

L'idée est de découpler les processus de dépôt et d'érosion (augmentation ou réduction de la charge sédimentaire) de ceux d'écoulement des fluides (création/dissipation de la surpression), comme cela est illustré par la **figure 3,** qui sera décrite plus en détail plus loin.

Plus précisément, au lieu de considérer la charge sédimentaire et la surpression comme deux paramètres interdépendants qu'il faut résoudre simultanément (d'où le grand nombre d'incréments nécessaires à chaque état), on va montrer qu'il est possible de déterminer a priori la variation de contrainte effective entre deux événements géologiques (et donc sur tout un état $A_i$), et ensuite sur cet état $A_i$ d'estimer la surpression sur la base de l'évolution de la contrainte effective estimée.

*Architecture*

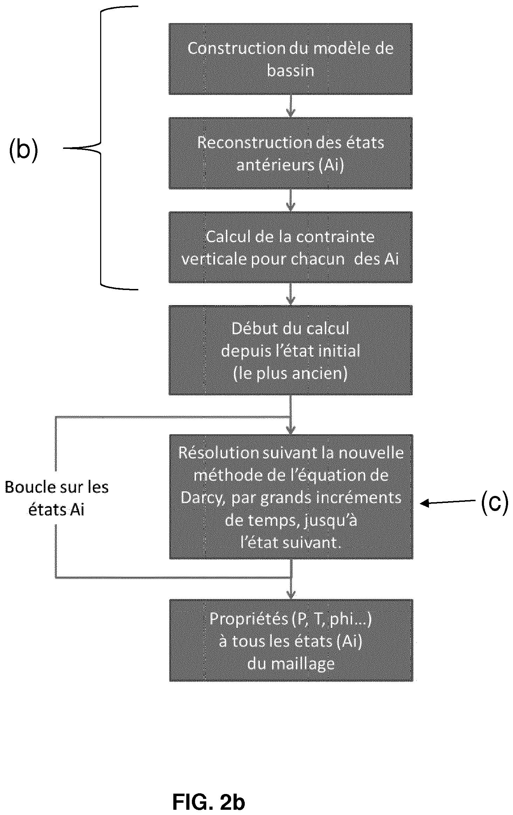

En référence à la **figure 2b,** est proposé un procédé de modélisation d'un bassin sédimentaire, ledit bassin sédimentaire ayant subi une pluralité d'événements géologiques définissant une séquence d'états $\{A_i\}$ du bassin chacun s'étendant entre deux événements géologiques successifs.

Le présent procédé est typiquement mis en œuvre au sein d'un équipement tel que représenté par la **figure**

**4** (par exemple un poste de travail informatique) équipé de moyens de traitement de données 21 (un processeur) et de moyens de stockage de données 22 (une mémoire, en particulier un disque dur), typiquement pourvu d'une interface d'entrée et de sortie 23 pour saisir des données et restituer les résultats du procédé.

Le procédé utilise comme expliqué des données relatives au bassin sédimentaire à étudier. Ces dernières peuvent être obtenues à partir par exemple de mesures diagraphiques réalisées le long de puits forés dans le bassin étudié, de l'analyse d'échantillons de roche prélevés par exemple par carottage, d'images sismiques obtenues suite à des campagnes d'acquisition sismique.

Dans une étape (a), de façon connue, les moyens de traitement de données 21 obtiennent des mesures de grandeurs physiques dudit bassin acquises depuis des capteurs 20. De manière non limitative, les capteurs 20 peuvent consister en des outils de mesures diagraphiques, en des capteurs sismiques, en des préleveurs et analyseurs de fluide, etc.

Au vu de la longueur et la complexité des campagnes de mesures sismiques, stratigraphiques et sédimentologiques (et de façon générale des campagnes géologiques), lesdites mesures sont généralement accumulées via des dispositifs dédiés 10 permettant de recueillir et stocker de telles mesures depuis les capteurs 20.

Ces mesures de grandeurs physiques du bassin peuvent être de nombreux types, et on citera en particulier des hauteurs d'eau, des types de sédiment déposés, des hauteurs de sédimentation ou d'érosion, des contraintes latérales à la frontière du domaine, des flux latéraux à la frontière du domaine, etc.

L'homme du métier pourra s'appuyer sur le document « Contribution de la mécanique à l'étude des bassins sédimentaires : modélisation de la compaction chimique et simulation de la compaction mécanique avec prise en compte d'effets tectonique », par Anne-Lise Guilmin, 10 septembre 2012, Ecole des Ponts ParisTech, pour choisir les grandeurs physiques d'intérêt.

Dans une étape (b), pour chacun desdits états $A_i$, les moyens de traitement de données 21 construisent (ou reconstruisent) une représentation maillée du bassin en fonction desdites mesures de grandeurs physiques. La représentation maillée modélise le bassin sous la forme d'un ensemble de mailles élémentaires appelées aussi « cellules ».

Comme l'on verra, il est souhaitable que l'étape (b) comprenne pour chaque état la détermination d'une contrainte verticale totale sur chaque maille de la représentation maillée.

De façon connue, l'homme du métier saura utiliser les techniques connues de backstripping ou de reconstruction structurale pour réaliser cette étape. Dans la suite de la présente description, on prendra l'exemple du backstripping, mais le présent procédé ne sera pas limité à une représentation maillée particulière.

Le présent procédé se distingue tout particulièrement en ce qu'il comprend, comme expliqué, des étapes (c).1 et (c).2 qui vont être mises en œuvre de façon récursive pour chacun des états $A_i$. Dans la suite de la présente description, on prendra l'exemple d'un unique incrément de temps par état $A_i$ (i.e. longueur du pas de temps = longueur de l'état), ce qui suffira le plus souvent, mais on comprendra que si les circonstances l'exigent l'homme du métier pourra placer plusieurs incréments dans un état (i.e. calculer des valeurs intermédiaires de contrainte effective et de surpression), si par exemple il est d'une durée particulièrement longue. En pratique, les incréments seront 5 à 100 fois plus longs, et le nombre d'étapes de calcul divisé d'autant.

De façon générale, l'étape (c) comprend, pour chacun desdits états $A_i$, et pour chaque maille de la représentation maillée :

1. Le calcul d'une contrainte effective appliquée sur la maille à la fin de l'état $A_i$ ;
2. Le calcul d'une surpression dans la maille à la fin de l'état $A_i$ en fonction de ladite contrainte effective.

Comme on le verra, le caractère récursif tient en ce que le calcul d'une contrainte effective appliquée sur la maille à la fin de l'état $A_i$ implique avantageusement la valeur de la contrainte effective à la fin de l'état précédent $A_{i-1}$, et le calcul de la surpression implique avantageusement la valeur de la contrainte effective à la fin de l'état précédent $A_{i-1}$ et du présent état $A_i$ ainsi que la valeur de surpression dans la maille à la fin de l'état précédent $A_{i-1}$.

On peut résumer cela de la sorte :

1. calcul d'une contrainte effective appliquée sur la maille à la fin de l'état $A_i$ à partir de la contrainte effective appliquée sur la maille à la fin de l'état précédent $A_{i-1}$ ;
2. calcul d'une surpression dans la maille à la fin de l'état $A_i$ en fonction des contraintes effectives appliquées sur la maille à la fin de l'état $A_i$ et à la fin de l'état précédent $A_{i-1}$, et de la surpression dans la maille à la fin de l'état précédent $A_{i-1}$ ;

L'étape (c).1 est une étape de calcul des contraintes effectives appliquées sur le bassin. Plus précisément, est calculée pour chaque maille de la représentation maillée, et ce pour chaque état $A_i$, ladite contrainte effective à la fin de l'état $A_i$.

L'étape (c).1 permet ainsi de déterminer a priori la variation de contrainte effective entre deux événements géologiques (i.e. pendant un état $A_i$). Connaissant la contrainte effective dans chaque maille du modèle au début de l'état considéré $A_i$ (égale à celle à la fin de l'état précédent $A_{i-1}$), notée $\sigma_{initial}$, on calcule une contrainte effective additionnelle notée $\sigma_{eff\_add}$, que l'on ajoute à la contrainte $\sigma_{initial}$ pour obtenir $\sigma_{eff}$.

Selon un mode de réalisation de l'invention, la contrainte effective correspond à la contrainte lithostatique. On appelle contrainte lithostatique la contrainte verticale correspondant au poids des roches sus-jacentes. La contrainte lithostatique additionnelle correspond ainsi à la variation de poids des roches sus-jacente pendant l'état $A_i$, c'est-à-dire le dépôt ou l'érosion. Dans le cas de la contrainte lithostatique, les roches sont considérées comme non poreuses, ou autrement dit la contrainte lithostatique ne comprend pas le poids des fluides présents dans les pores des roches sus-jacentes.

Selon une mode de réalisation de l'invention, la contrainte effective correspond à la contrainte totale. La contrainte totale correspond au poids des roches sus-jacentes, les roches étant considérées comme un milieu poreux pouvant comprendre des fluides tels que de l'eau. La contrainte totale additionnelle correspond ainsi à la variation de poids des roches sus-jacente pendant l'état $A_i$, c'est-à-dire le dépôt ou l'érosion.

On connaît également l'épaisseur de sédiment déposé ou érodé durant ce même état $A_i$. Par conséquent :

- Dans le cas d'un dépôt sédimentaire, l'étape (b) fournit la contrainte verticale totale additionnelle $\Delta\sigma_v$ (comme différence entre les contraintes verticales totales à la fin des états respectivement considéré $A_i$ et précédent $A_{i-1}$) et la contrainte effective additionnelle théorique $\Delta\tilde{\sigma}$ dans l'hypothèse où ces sédiments additionnels sont à la pression hydrostatique (ce qui est généralement le cas car ces sédiments fraîchement déposés sont généralement très poreux et très perméables).
- Dans le cas d'une érosion, la contrainte verticale totale additionnelle $\Delta\sigma_v$ et la contrainte effective additionnelle théorique $\Delta\tilde{\sigma}$ de la partie retirée de la colonne sédimentaire sont connues grâce au calcul effectué à l'état précédent $A_{i-1}$.

Pour reformuler encore, connaissant le volume solide de la charge additionnelle, le backstripping (étape (b)) donne la porosité sous l'hypothèse de pression hydrostatique. On connaît donc la charge totale additionnelle (contrainte additionnelle) et on en déduit la contrainte effective additionnelle (charge totale - pression hydrostatique équivalente à l'épaisseur sédimentée) $\sigma_{eff\_add}$

Il est alors possible de calculer à partir de la contrainte effective dans l'étape (c).2 la surpression car en chaque point de la colonne sédimentaire, la variation de la contrainte effective est alors la somme de $\Delta\sigma$, uniforme sur toute la colonne (formée par la maille courante et les mailles sus-jacentes), et de la variation de surpression au point considéré (qui correspond donc à l'écart avec la pression hydrostatique).

Dans cette étape (c).2, les moyens de traitement de données 21 estiment ainsi la surpression à la fin de l'état géologique considéré $A_i$ sur la base de l'évolution de contrainte effective estimée à l'étape précédente.

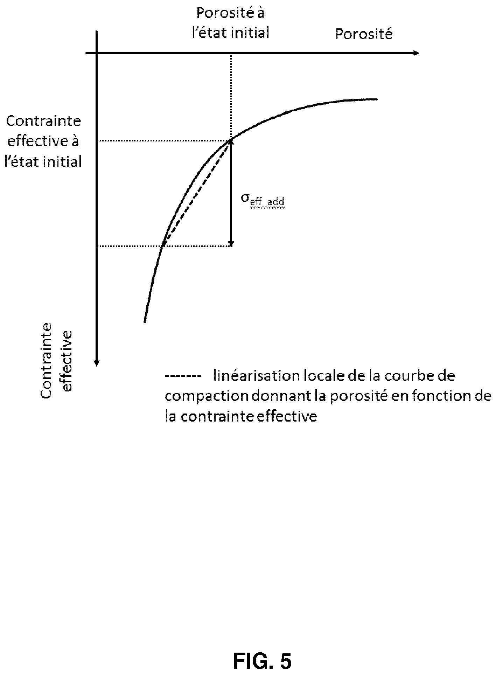

Selon une mise en œuvre très préférée de l'invention, on linéarise localement la courbe d'évolution de la porosité en fonction de la charge comme l'on voit sur la **figure 5**. Cela est le point-clé qui permet de résoudre l'équation de Darcy sur un grand pas de temps (jusqu'à toute la longueur de l'état $A_i$), et non par petits incréments en se déplaçant sur cette courbe.

L'hypothèse sous-jacente est que le taux de variation du volume poreux est constant au cours de l'état $A_i$ et traduit ainsi une évolution linéaire du volume poreux par rapport à la surpression. Ce qui permet une estimation rapide de cette dernière par une équation de Darcy « simplifiée » liant directement la surpression en début et fin de l'état $A_i$ selon la formule suivante :

$$\frac{Vol_{s,k}}{\Delta t} c_k \left( oP_k^i - oP_k^{i-1} \right) + \int_{\delta k} \frac{-K}{\mu} \overrightarrow{grad}\, oP_k^i \cdot \vec{n}_k = -\frac{Vol_{s,k}}{\Delta t} \Delta\tilde{\sigma}\epsilon_k$$

Avec :

$C_k$ la variation de taux de vide (volume poreux sur volume solide) sur la variation de contrainte effective sous l'hypothèse de pression hydrostatique,
$Vol_{s,k}$ le volume solide de la maille k considérée,
$\mu$ la viscosité cinématique du fluide,
$K$ la perméabilité intrinsèque de la roche,
$\Delta t$ la durée de l'état considéré,
$oP^i$ la surpression à la fin de l'état $A_i$,
$\Delta\tilde{\sigma}\epsilon$ la contrainte effective additionnelle théorique dans l'hypothèse où ces sédiments additionnels ont une pression hydrostatique.

En résumé, l'étape (c).2 comprend avantageusement, le calcul d'un taux de variation de la contrainte effective pendant l'état $A_i$ en fonction de la contrainte effective à la fin de l'état $A_i$ et de la contrainte effective à la fin de l'état précédent $A_{i-1}$.

De façon classique, l'étape (c) pourra comprendre par ailleurs la simulation numérique (le cas échéant sur un pas de temps plus court) d'au moins un phénomène physique de sorte à estimer, outre la surpression, toute grandeur du bassin sédimentaire qui pourrait intéresser l'homme du métier, telles que les saturations en fluide, les températures etc.

*Mode de réalisation préféré*

Selon un mode de réalisation très avantageux, le présent procédé propose d'éviter de mettre en œuvre le calcul de la surpression de l'étape (c).2 si celui-ci n'est pas nécessaire.

En effet, il arrive souvent que, dans les phases les plus précoces de l'histoire géologique d'un bassin sédimentaire, le champ de pression soit à l'équilibre hydrostatique, i.e. la surpression est nulle en tout point du bassin. Il est alors possible de connaître directement la pression en tout point du bassin sans résoudre l'équation de Darcy ni même l'équation simplifiée présentée ci-avant. Il suffit d'appliquer la formule :

$$P_z = P_{atm} + \rho_w g z,$$

avec $P_z$ la pression à la profondeur $z$, $P_{atm}$ la pression atmosphérique, $\rho_w$ la masse volumique de l'eau, g l'accélération de la pesanteur.

Pour que l'on puisse générer une pression qui s'écarte de l'équilibre hydrostatique, il faut que le volume de fluide à mettre en mouvement du fait des changements de conditions géologiques soit supérieur au volume d'eau que les propriétés d'écoulement permettent de faire circuler. En supposant un flux d'eau purement vertical, on peut calculer pendant chaque état $A_i$, en chacune des mailles du modèle géologique la différence entre le volume de fluide à mettre en mouvement et le volume qui peut effectivement s'écouler du fait de la perméabilité de la roche. Il est alors possible de savoir s'il existe une source possible de pression anormale. Si aucune source de pression anormale n'existe (ou si le terme source est inférieur à un critère) pendant la durée d'un état $A_i$ on estime alors que le bassin est à l'équilibre hydrostatique. Le calcul de ce bilan étant nettement plus rapide que la résolution de l'équation de Darcy, il est possible de n'utiliser la résolution complète de l'équation de Darcy, même présentement simplifiée que lorsque cela s'avère nécessaire et ainsi réduire drastiquement les temps de calcul.

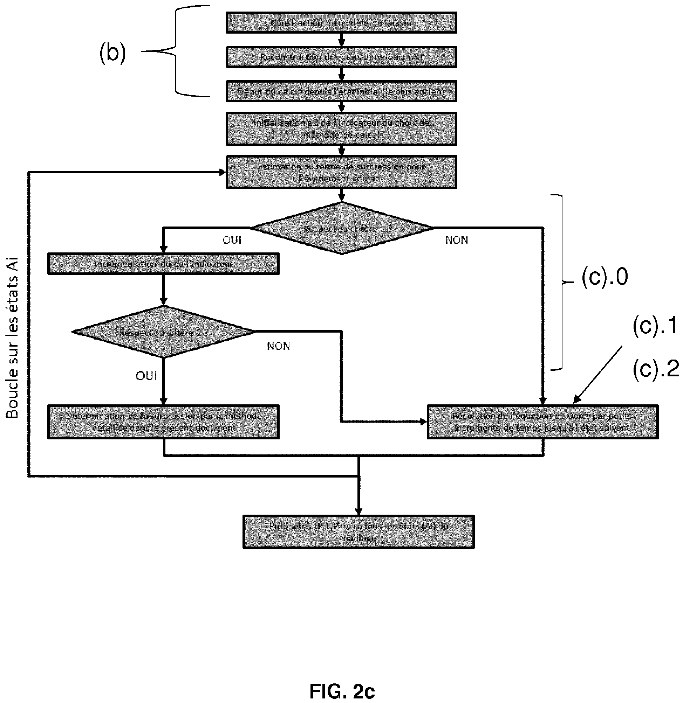

Ainsi, en référence à la **figure 2c,** l'étape (c) comprend préférentiellement une étape préalable (c).0 de vérification que, pour au moins une desdites mailles, la surpression a varié pendant l'état $A_i$ de plus qu'au moins un seuil prédéterminé, et à l'issue de laquelle la suite de l'étape (c) est mise en œuvre seulement si cela est vérifié. Alternativement, si cela n'est pas vérifié, le champ de pression est à l'équilibre hydrostatique et on peut appliquer la formule : $P_z = P_{atm} + \rho_w g z$ (i.e. la surpression est nulle partout).

Comme l'on verra avantageusement deux seuils prédéterminés sont utilisés : un premier seuil est utilisé pour chaque maille, et si ce premier seuil est vérifié partout, un deuxième seuil « d'erreur cumulée » est testé. Le spécialiste a parfaite connaissance pour déterminer les valeurs de ces seuils, en fonction de la précision attendue pour l'estimation des surpressions.

Pour mettre en œuvre cette procédure de vérification, un bilan entre le volume de fluide à mettre en mouvement et le volume de fluide mobile est effectué pour chaque état $A_i$. De façon générale, l'étape (c).0 comprend le calcul d'une valeur de surpression théorique qui se développerait dans la maille sous l'hypothèse d'une pression hydrostatique.

Il faut bien comprendre que l'étape de vérification ne calcule pas la surpression dans la maille à la fin de l'état $A_i$ ni même sa variation réelle pendant l'état $A_i$, mais en estime seulement une variation théorique (grâce à l'hypothèse d'une pression hydrostatique). Cette valeur théorique s'avère facile à calculer et est représentative de la valeur réelle. Cela constitue ainsi un test fiable de la nécessité ou non de résoudre une équation du type de l'équation de Darcy.

Comme expliqué un deuxième seuil d'erreur cumulée (ou erreur totale) peut être utilisé. En d'autres termes, l'étape (c).0 comprend avantageusement en outre la vérification que pour au moins une desdites mailles la surpression a varié depuis le dernier état $A_{j,j<i}$ lors duquel la suite de l'étape (c) a été mise en œuvre, de plus qu'un deuxième seuil prédéterminé. Il faut comprendre que les deux vérifications sont cumulatives : si au moins un des tests est vérifié (erreur simple au-dessus du premier seuil OU erreur cumulée au-dessus du deuxième seuil), la résolution de l'équation de Darcy est mise en œuvre, et si aucun des tests n'est vérifié (erreur simple en-dessous du premier seuil ET erreur cumulée en-dessous du deuxième seuil), la résolution de l'équation de Darcy n'est pas mise en œuvre.

De façon particulièrement préférée, on utilise pour ce test d'erreur totale des « indicateurs » associés à chacune des mailles qui seront décrits plus loin. Ces indicateurs permettent de sommer les petites surpressions théoriques qui sont ignorées de sorte à forcer la résolution de l'équation de Darcy au bout d'un certain temps lorsque l'erreur totale n'est plus acceptable. Plus précisément, si pour toutes les mailles la suite de l'étape (c) n'est pas mise en œuvre (i.e.

si une valeur de surpression théorique calculée est inférieure audit premier seuil), alors on incrémente l'indicateur, et si elle est mise en œuvre pour au moins une maille, les indicateurs sont remis à zéro.

En résumé, l'étape (c).0 comprend avantageusement le calcul pour chaque maille d'un indicateur :

- Si pour chaque maille la valeur calculée de surpression théorique qui se développerait dans la maille sous l'hypothèse d'une pression hydrostatique est inférieure audit premier seuil, chaque indicateur est incrémenté de la valeur calculée de surpression théorique qui se développerait dans la maille (correspondante) sous l'hypothèse d'une pression hydrostatique ;
- Si pour au moins une maille la valeur calculée de surpression théorique qui se développerait dans la maille sous l'hypothèse d'une pression hydrostatique est inférieure audit premier seuil ou la valeur de l'indicateur (associé à la maille) est supérieure audit deuxième seuil, chaque indicateur est remis à zéro.

Pour reformuler encore, l'étape (c) comprend, pour chacun desdits états $A_i$, et pour chaque maille de ladite représentation maillée, la vérification que, pour au moins une desdites mailles, une surpression a varié pendant l'état $A_i$ de plus qu'un premier seuil prédéterminé (et avantageusement la vérification supplémentaire que pour au moins une desdites mailles, la surpression a varié depuis le dernier état $A_{j,j<i}$ lors duquel la suite de l'étape (c) a été mise en œuvre, de plus qu'un deuxième seuil prédéterminé), et si (et seulement si) cela (au moins une des deux vérifications) est vérifié, le calcul de la surpression dans la maille à la fin de l'état $A_i$ selon l'étape (c).2.

Selon un mode de réalisation particulièrement préféré :

a. Au premier état $A_0$, on initialise à 0 dans chaque maille l'indicateur qui sera utilisé pour déterminer la méthode de calcul du terme de pression (pression hydrostatique ou par résolution effective d'une équation du type équation de Darcy).

b. Pour chaque état $A_i$ :

i. On calcule d'abord, dans chaque maille du modèle, le volume de fluide qui doit s'écouler du fait des changements de conditions géologiques dans la maille pour conserver un milieu saturé en fluide. Cette valeur correspond à la différence de volume de la maille pendant la durée de l'état $A_i$, déterminé par exemple par la méthode de restauration structurale *backward* (méthode de type backstripping pour la mise en œuvre de l'étape (b)). Ce volume est négatif dans le cas où le volume de la maille augmente.

ii. On estime une valeur de surpression, $oP^i$, qui se développerait dans la maille si celle-ci suivait exactement l'évolution de volume donnée par le calcul *backward* (c'est-à-dire sous l'hypothèse d'une pression hydrostatique).

$$V = q \times \Delta t \times S = \frac{V}{\Delta \tilde{\sigma}} \times oP + \frac{k}{\mu} \times S \times \frac{oP^i}{d} \times \Delta t$$

On remarque en particulier que si k (la perméabilité en m$^2$ de la maille en début de l'état) est très petit, on tombe bien sur $oP = \Delta \tilde{\sigma}$,

avec :

V la vitesse d'écoulement de l'eau (m/s);
$\Delta \tilde{\sigma}$ la variation de contrainte effective (Pa),
k la perméabilité (m$^2$),
q la vitesse de Darcy ou de filtration (m/s),
$oP^i$ la surpression théorique générée pendant l'état (kg/m/s2) (cette dernière peut être négative lorsque la différence de volume est négative).
$\mu$ la viscosité dynamique (kg/m/s) de l'eau
S la surface de la maille selon la normale à l'axe vertical (en m$^2$)
d la distance entre le centre de la maille et le centre de la face supérieure de la maille (en m).
g la norme vecteur accélération de la pesanteur (m/s$^2$)
$\Delta t$ la durée de l'état (en s)

iii. On compare le terme $oP^i$ pour chaque maille du modèle avec ledit premier seuil prédéterminé. Ce seuil correspond à l'erreur acceptable sur l'estimation de la surpression entre deux états du bassin sédimentaire.

1. Si aucune maille ne dépasse le critère, c'est-à-dire que la valeur absolue de $oP^i$ reste inférieure ou égale au premier seuil, on incrémente alors de $oP^i$ la valeur de l'indicateur dans chacune des mailles. On compare alors l'indicateur avec le deuxième seuil prédéterminé (empirique), correspondant à l'erreur totale « acceptable ».

a. Si ce second seuil n'est pas dépassé, on ne procède pas au calcul de la pression par résolution d'une équation de type de l'équation de Darcy. On suppose que, pendant cet état $A_i$, la surpression n'a pas évolué depuis l'état précédent $A_{i-1}$. En effet, cette situation traduit le fait que les conditions géologiques permettent d'accommoder les variations de volume de roche dans le bassin sans modification a priori de la surpression (selon les critères utilisés).

2. Si au moins l'un des deux seuils n'est pas respecté dans au moins l'une des mailles du modèle, il est nécessaire de résoudre l'équation de Darcy (étape (c).2) afin de connaître la distribution de surpression dans le bassin sédimentaire. La valeur de l'indicateur est alors remise à 0 dans l'ensemble du modèle.

*Restitution*

A l'issue de l'étape (c), répétée pour chaque maille et pour chaque état $A_i$, on dispose au moins de la valeur de surpression dans chaque maille au temps actuel.

En outre, en fonction du simulateur de bassin utilisé pour mettre en œuvre l'invention, on peut disposer d'informations supplémentaires sur la mise en place des couches sédimentaires, leur compaction sous l'effet du poids des sédiments susjacents, leur réchauffement au cours de leur enfouissement, la formation des hydrocarbures formés par thermogénèse, le déplacement de ces hydrocarbures dans le bassin sous l'effet de la flottabilité, de la capillarité, des différences de gradients de pression les écoulements souterrains, la quantité d'hydrocarbures issus de la thermogénèse dans les mailles de ladite représentation maillée dudit bassin.

A partir de telles informations, il est possible d'identifier des zones dudit bassin, correspondant à des mailles de ladite représentation maillée au temps actuel dudit bassin, comportant des hydrocarbures, ainsi que la teneur, la nature et la pression des hydrocarbures qui y sont piégés. Le spécialiste est alors en mesure de sélectionner les zones du bassin étudié présentant le meilleur potentiel pétrolier.

L'exploitation pétrolière du bassin peut alors prendre plusieurs formes, notamment :

- la réalisation de forages d'exploration dans les différentes zones sélectionnées comme présentant le meilleur potentiel, afin de confirmer ou infirmer le potentiel estimé préalablement, et d'acquérir de nouvelles données pour alimenter de nouvelles études plus précises,
- la réalisation de forages d'exploitation (puits producteurs ou injecteurs) pour la récupération des hydrocarbures présents au sein du bassin sédimentaire dans les zones sélectionnées comme présentant le meilleur potentiel.

Le procédé comprend ainsi préférentiellement une étape (d) de sélection des zones dudit bassin correspondant à des mailles de ladite représentation maillée dudit bassin audit temps actuel comportant des hydrocarbures, et/ou d'exploitation dudit bassin en fonction desdites zones sélectionnées.

Alternativement ou en complément, l'étape (d) peut comprendre la restitution sur l'interface 23 d'informations du bassin, telle qu'une représentation visuelle comme va être à présent décrite.

*Résultat*

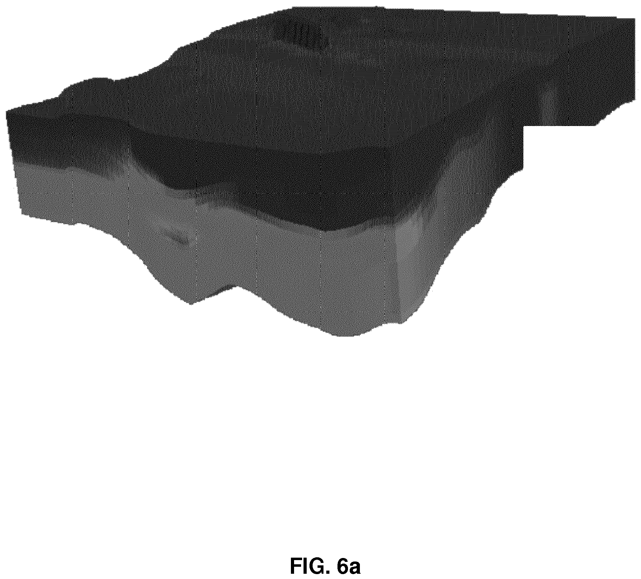

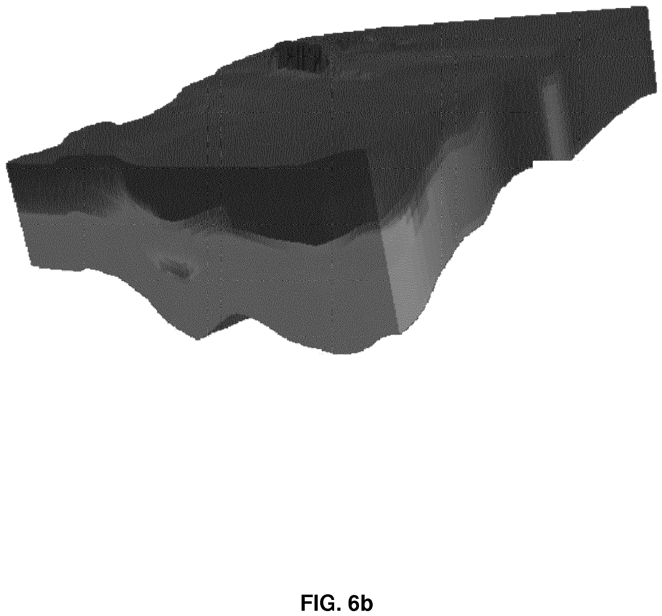

A titre purement illustratif, les **figures 6a et 6b** présentent les modèles d'un bassin sédimentaire (est représenté la valeur de surpression calculée pour chaque maille) obtenus par la mise en œuvre d'un procédé classique et d'un procédé selon l'invention.

On observe des qualités de modélisation similaires (des motifs identiques ont été mis en évidence) alors que les temps de simulation sont très différents : dans le cas du procédé classique (figure 6a), ce temps est de 24 minutes 31 secondes, alors que seulement 3 minutes 26 secondes sont nécessaires dans le cas du procédé selon l'invention (figure 6b). On observe un gain de temps d'un facteur 7, à ressources informatiques et qualité de modélisation égales.

*Equipement et produit programme d'ordinateur*

En outre il est proposé l'équipement 14 pour la mise en œuvre du présent procédé de modélisation d'un bassin sédimentaire.

Cet équipement 14 comprend comme expliqué des moyens de traitement de données 21, et avantageusement des moyens de stockage de données 22, et une interface 23.

Les moyens de traitement de données 21 sont configurés pour implémenter :

- Obtenir des mesures de grandeurs physiques dudit bassin acquises depuis des capteurs 20 ;
- Pour chacun desdits états $A_i$, construire une représentation maillée du bassin en fonction desdites mesures de grandeurs physiques ;
- Pour chacun desdits états $A_i$, et pour chaque maille de la représentation maillée,

    1. calculer une contrainte effective appliquée sur la maille à la fin de l'état $A_i$ ;
    2. calculer une surpression dans la maille à la fin de l'état $A_i$ en fonction de ladite contrainte effective calculée à la fin de l'état $A_i$.

Selon un autre aspect, l'invention concerne également un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé selon le premier aspect, lorsque ledit programme est exécuté sur un ordinateur.

**Revendications**

**1.** Procédé de modélisation d'un bassin sédimentaire, ledit bassin sédimentaire ayant subi une pluralité d'événements géologiques définissant une séquence d'états $\{A_i\}$ du bassin, chacun desdits états s'étendant entre deux événements géologiques successifs, le procédé comprenant la mise en œuvre par des moyens de traitement de données (21) d'étapes de :

    (a) Obtention de mesures de grandeurs physiques dudit bassin acquises depuis des capteurs (20) ;
    (b) Pour chacun desdits états $A_i$, construction d'une représentation maillée dudit bassin en fonction desdites mesures de grandeurs physiques ;
    le procédé est **caractérisé en ce qu'**il comprend en outre une étape de:
    (c) Pour chacun desdits états $A_i$, et pour chaque maille de ladite représentation maillée,

        1. calcul d'une contrainte effective appliquée sur la maille à la fin de l'état $A_i$, ladite contrainte effective à la fin dudit état $A_i$ étant calculée en fonction de ladite contrainte effective à la fin de l'état précédent $A_{i-1}$ et d'une contrainte effective additionnelle sur ledit état $A_i$ fonction d'une variation d'épaisseur de sédiment pendant ledit état $A_i$;
        2. calcul d'une surpression dans la maille à la fin de l'état $A_i$ en fonction de ladite contrainte effective calculée à la fin de l'état $A_i$.

**2.** Procédé selon la revendication 1, comprenant une étape (d) de sélection des zones dudit bassin correspondant à des mailles de ladite représentation maillée dudit bassin au temps actuel comportant des hydrocarbures.

**3.** Procédé selon la revendication 2, dans lequel l'étape (d) comprend l'exploitation dudit bassin en fonction desdites zones sélectionnées.

**4.** Procédé selon l'une des revendications 1 à 3, dans lequel l'étape (b) est mise en œuvre par backstripping ou reconstruction structurale.

**5.** Procédé selon l'une des revendications 1 à 4, dans lequel l'étape (b) comprend pour chaque maille et chaque état $A_i$ la détermination d'une contrainte verticale totale sur la maille, ladite contrainte effective additionnelle étant calculée à l'étape (c) comme la contrainte verticale totale additionnelle $A_i$ par rapport à l'état précédent $A_{i-1}$, moins la pression hydrostatique équivalente à la variation d'épaisseur de sédiment.

**6.** Procédé selon l'une des revendication 1 à 5, dans lequel l'étape (c).2 comprend le calcul d'un taux de variation de la contrainte effective pendant l'état $A_i$ en fonction de la contrainte effective à la fin de l'état $A_i$ et de la contrainte effective à la fin de l'état précédent $A_{i-1}$.

**7.** Procédé selon la revendication 6, dans lequel l'étape (c).2 comprend le calcul d'un taux de variation d'un volume poreux de la maille pendant l'état $A_i$ en supposant constant le taux de variation de la contrainte effective pendant l'état $A_i$, de sorte à obtenir la surpression à la fin de l'état $A_i$ par résolution d'une équation de Darcy simplifiée.

EP 3 502 753 B1

8.  Procédé selon l'une des revendications 1 à 7, dans lequel l'étape (c) comprend une étape préalable (c).0 de vérification que pour au moins une desdites mailles la surpression a varié pendant l'état $A_i$ de plus qu'un premier seuil prédéterminé, et de mise en œuvre de la suite de l'étape (c) seulement si cela est vérifié.

9.  Procédé selon la revendication 8, dans lequel l'étape (c).0 comprend le calcul d'une valeur de surpression théorique qui se développerait dans la maille sous l'hypothèse d'une pression hydrostatique.

10. Procédé selon l'une des revendications 8 à 9, dans lequel l'étape (c).0 comprend en outre la vérification que pour au moins une desdites mailles la surpression a varié depuis le dernier état $A_{j,j<i}$ lors duquel la suite de l'étape (c) a été mise en œuvre, de plus qu'un deuxième seuil prédéterminé.

11. Procédé selon les revendications 9 et 10 en combinaison, dans lequel l'étape (c).0 comprend le calcul pour chaque maille d'un indicateur :

    - Si pour chaque maille la valeur calculée de surpression théorique qui se développerait dans la maille sous l'hypothèse d'une pression hydrostatique est inférieure audit premier seuil, chaque indicateur est incrémenté de la valeur calculée de surpression théorique qui se développerait dans la maille sous l'hypothèse d'une pression hydrostatique ;
    - Si pour au moins une maille la valeur calculée de surpression théorique qui se développerait dans la maille sous l'hypothèse d'une pression hydrostatique est supérieure audit premier seuil ou la valeur de l'indicateur est supérieure audit deuxième seuil, chaque indicateur est remis à zéro.

12. Produit programme d'ordinateur téléchargeable depuis un réseau de communication et/ou enregistré sur un support lisible par ordinateur et/ou exécutable par un processeur, comprenant des instructions de code de programme pour la mise en œuvre du procédé selon l'une des revendications 1 à 11, lorsque ledit programme est exécuté sur un ordinateur.

**Patentansprüche**

1.  Modellierungsverfahren eines Sedimentbeckens, wobei das Sedimentbecken einer Vielzahl von geologischen Ereignissen ausgesetzt war, die eine Sequenz von Zuständen $\{A_i\}$ des Beckens definieren, wobei sich jeder der Zustände zwischen zwei aufeinanderfolgenden geologischen Ereignissen erstreckt, wobei das Verfahren die Umsetzung folgender Schritte durch Datenverarbeitungsmittel (21) beinhaltet:

    (a) Erhalten von Messungen physikalischer Größen des Beckens, die durch Sensoren (20) erfasst werden;
    (b) für jeden der Zustände $A_i$, Konstruieren einer Maschendarstellung des Beckens in Abhängigkeit von den Messungen physikalischer Größen;

    wobei das Verfahren **dadurch gekennzeichnet ist, dass** es ferner einen folgenden Schritt beinhaltet:
    (c) für jeden der Zustände $A_i$ und für jede Masche der Maschendarstellung

    1. Berechnen einer effektiven Spannung, die am Ende des Zustands $A_i$ auf die Masche wirkt, wobei die effektive Spannung am Ende des Zustands $A_i$ in Abhängigkeit von der effektiven Spannung am Ende des vorhergehenden Zustands $A_{i-1}$ und einer zusätzlichen effektiven Spannung auf den Zustand $A_i$, die von einer Änderung der Sedimentdicke während des Zustands $A_i$ abhängt, berechnet wird;
    2. Berechnen eines Überdrucks in der Masche am Ende des Zustands $A_i$ in Abhängigkeit von der berechneten effektiven Spannung am Ende des Zustands $A_i$.

2.  Verfahren nach Anspruch 1, das einen Schritt (d) des Auswählens der Bereiche des Beckens beinhaltet, die Maschen der Maschendarstellung des Beckens zum aktuellen Zeitpunkt entsprechen, die Kohlenwasserstoffe umfassen.

3.  Verfahren nach Anspruch 2, wobei Schritt (d) die Erschließung des Beckens in Abhängigkeit von den ausgewählten Bereichen beinhaltet.

4.  Verfahren nach einem der Ansprüche 1 bis 3, wobei Schritt (b) durch Backstripping oder strukturelle Rekonstruktion umgesetzt wird.

12

**5.** Verfahren nach einem der Ansprüche 1 bis 4, wobei Schritt (b) für jede Masche und jeden Zustand $A_i$ das Bestimmen einer vertikalen Gesamtspannung auf die Masche beinhaltet, wobei die zusätzliche effektive Spannung in Schritt (c) als die zusätzliche vertikale Gesamtspannung $A_i$ in Bezug auf den vorhergehenden Zustand $A_{i-1}$ minus den hydrostatischen Druck, der der Änderung der Sedimentdicke entspricht, berechnet wird.

**6.** Verfahren nach einem der Ansprüche 1 bis 5, wobei Schritt (c).2 das Berechnen einer Änderungsrate der effektiven Spannung während des Zustands $A_i$ in Abhängigkeit von der effektiven Spannung am Ende des Zustands $A_i$ und der effektiven Spannung am Ende des vorhergehenden Zustands $A_{i-1}$ beinhaltet.

**7.** Verfahren nach Anspruch 6, wobei Schritt (c).2 das Berechnen einer Änderungsrate eines Porenvolumens der Masche während des Zustands $A_i$ unter der Annahme, dass die Änderungsrate der effektiven Spannung während des Zustands $A_i$ konstant ist, beinhaltet, um den Überdruck am Ende des Zustands $A_i$ durch Lösen einer vereinfachten Darcy-Gleichung zu erhalten.

**8.** Verfahren nach einem der Ansprüche 1 bis 7, wobei Schritt (c) einen Vorabschritt (c).0 des Verifizierens, dass sich für mindestens eine der Maschen der Überdruck während des Zustands $A_i$ um mehr als einen ersten vorgegebenen Schwellenwert geändert hat, und des Umsetzens des weiteren Schritts (c) nur dann, wenn dies verifiziert wird, beinhaltet.

**9.** Verfahren nach Anspruch 8, wobei Schritt (c).0 das Berechnen eines theoretischen Überdruckwerts beinhaltet, der sich unter der Annahme eines hydrostatischen Drucks in der Masche entwickeln würde.

**10.** Verfahren nach einem der Ansprüche 8 bis 9, wobei Schritt (c) .0 ferner das Verifizieren beinhaltet, dass sich der Überdruck für mindestens eine der Maschen seit dem letzten Zustand $A_{j,j<i}$, bei dem der weitere Schritt (c) umgesetzt wurde, um mehr als einen zweiten vorgegebenen Schwellenwert geändert hat.

**11.** Verfahren nach den Ansprüchen 9 und 10 in Kombination, wobei Schritt (c).0 für jede Masche das Berechnen eines Indikators beinhaltet:

- wenn für jede Masche der berechnete Wert des theoretischen Überdrucks, der sich unter der Annahme eines hydrostatischen Drucks in der Masche entwickeln würde, kleiner als der erste Schwellenwert ist, wird jeder Indikator um den berechneten Wert des theoretischen Überdrucks, der sich unter der Annahme eines hydrostatischen Drucks in der Masche entwickeln würde, inkrementiert;
- wenn für mindestens eine Masche der berechnete Wert des theoretischen Überdrucks, der sich unter der Annahme eines hydrostatischen Drucks in der Masche entwickeln würde, größer als der erste Schwellenwert ist oder der Wert des Indikators größer als der zweite Schwellenwert ist, wird jeder Indikator auf Null zurückgesetzt.

**12.** Computerprogrammprodukt, das aus einem Kommunikationsnetzwerk heruntergeladen und/oder auf einem computerlesbaren Medium aufgezeichnet und/oder von einem Prozessor ausgeführt werden kann, das Programmcodeanweisungen zur Umsetzung des Verfahrens nach einem der Ansprüche 1 bis 11 beinhaltet, wenn das Programm auf einem Computer ausgeführt wird.

**Claims**

**1.** Method for modelling a sedimentary basin, said sedimentary basin having undergone a plurality of geological events defining a sequence of states $\{A_i\}$ of the basin, each of said states extending between two successive geological events, the method comprising the implementation by data processing means (21) of steps of:

(a) obtaining measurements of physical quantities of said basin, which are acquired from sensors (20);
(b) for each of said states $A_i$, constructing a meshed representation of said basin depending on said measurements of physical quantities;

the method is **characterized in that** it further comprises a step of:
(c) for each of said states $A_i$, and for each cell of said meshed representation,

1. computing an effective stress applied to the cell at the end of the state $A_i$, said effective stress at the end of

said state $A_i$ being computed depending on said effective stress at the end of the preceding state $A_{i-1}$ and on an additional effective stress on said state $A_i$ dependent on a change in sediment thickness during said state $A_i$;
2. computing an overpressure in the cell at the end of the state $A_i$ depending on said effective stress computed at the end of the state $A_i$.

2.  Method according to Claim 1, comprising a step (d) of selecting regions of said basin corresponding to cells of said meshed representation of said basin at the current time containing hydrocarbons.

3.  Method according to Claim 2, wherein step (d) comprises developing said basin depending on said selected regions.

4.  Method according to one of Claims 1 to 3, wherein step (b) is implemented by backstripping or structural reconstruction.

5.  Method according to one of Claims 1 to 4, wherein step b) comprises, for each cell and each state $A_i$, determining a total vertical stress on the cell, said additional effective stress being computed in step (c) to be the additional total vertical stress $A_i$ with respect to the preceding state $A_{i-1}$, minus the hydrostatic pressure equivalent to the change in sediment thickness.

6.  Method according to one of Claims 1 to 5, wherein, step (c).2 comprises computing a rate of change in the effective stress during the state $A_i$ depending on the effective stress at the end of the state $A_i$ and on the effective stress at the end of the preceding state $A_{i-1}$.

7.  Method according to Claim 6, wherein step (c).2 comprises computing a rate of change in a porous volume of the cell during the state $A_i$ while assuming the rate of change in the effective stress during the state $A_i$ to be constant, so as to obtain the overpressure at the end of the state $A_i$ by solving a simplified Darcy equation.

8.  Method according to one of Claims 1 to 7, wherein step (c) comprises a prior step (c).0 of verifying that for at least one of said cells the overpressure has changed during the state $A_i$ by more than a first preset threshold, and of implementing the rest of step (c) only if this is verified.

9.  Method according to Claim 8, wherein step (c).0 comprises computing a value of the theoretical overpressure that would develop in the cell under the assumption of a hydrostatic pressure.

10. Method according to one of Claims 8 to 9, wherein step (c).0 furthermore comprises verifying that for at least one of said cells the overpressure has changed, from the last state $A_{i,j<i}$ in which the rest of step (c) was implemented, by more than a second preset threshold.

11. Method according to Claims 9 and 10 in combination, wherein step (c).0 comprises computing, for each cell, an indicator:

    - if for each cell the computed value of the theoretical overpressure that would develop in the cell under the assumption of a hydrostatic pressure is lower than said first threshold, each indicator is incremented by the computed value of the theoretical overpressure that would develop in the cell under the assumption of a hydrostatic pressure;
    - if for at least one cell the computed value of the theoretical overpressure that would develop in the cell under the assumption of a hydrostatic pressure is higher than said first threshold or the value of the indicator is higher than said second threshold, each indicator is reset to zero.

12. Computer program product downloadable from a communication network and/or stored on a medium that is readable by computer and/or executable by a processor, comprising program code instructions for implementing the method according to one of Claims 1 to 11, when said program is executed on a computer.

FIG. 1

**FIG. 2a**

Etat de la technique

**FIG. 2b**

**(b)**

Construction du modèle de bassin

Reconstruction des états antérieurs (Ai)

Début du calcul depuis l'état initial (le plus ancien)

Initialisation à 0 de l'indicateur du choix de méthode de calcul

Estimation du terme de surpression pour l'évènement courant

Respect du critère 1 ?

OUI

NON

Incrémentation du de l'indicateur

**(c).0**

**(c).1**

**(c).2**

Respect du critère 2 ?

NON

OUI

Boucle sur les états Ai

Détermination de la surpression par la méthode détaillée dans le présent document

Résolution de l'équation de Darcy par petits incréments de temps jusqu'à l'état suivant

Propriétés (P,T,Phi...) à tous les états (Ai) du maillage

# FIG. 2c

Charge additionnelle
sédimentée entre
l'état initial et le
nouvel état

Etat initial

FIG. 3

FIG. 4

FIG. 5

FIG. 6a

FIG. 6b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2110686 A
- US 8150669 B
- EP 2816377 A
- US 20140377872 A
- EP 3075947 A
- US 20160290107 A
- EP 3182176 A
- US 20170177764 A
- US 20100223039 A

**Littérature non-brevet citée dans la description**

- **STECKLER, M.S. ; A.B. WATTS.** Subsidence of the Atlantic-type continental margin off New York. *Earth Planet. Sci. Lett.,* 1978, vol. 41, 1-13
- **GRAULS, D.** Overpressure assessment using a minimum principal stress approach - Overpressures in petroleum exploration. *Proc Workshop, Paul, Avril 1998 - Bulletin du centre de recherche Elf Exploration et Production, Mémoire,* vol. 22, ISSN 1279-8215, ISBN 2-901 026-49-4, 137-147
- Contribution de la mécanique à l'étude des bassins sédimentaires : modélisation de la compaction chimique et simulation de la compaction mécanique avec prise en compte d'effets tectonique. *Anne-Lise Guilmin,* 10 Septembre 2012